# EUROPEAN PATENT APPLICATION

(11) **EP 4 794 504 A1**
(43) Date of publication of application: **19.08.2026**
(21) Application number: 24793721.2
(22) Date of filing: 15.03.2024
(51) Int. Cl.: H10N 10/01, H10N 10/10, H10N 10/80, H10N 19/00

(54) **LOW-COST AND HIGH-STRENGTH THERMOELECTRIC MODULE MANUFACTURING METHOD HAVING SIMPLIFIED MANUFACTURING PROCESS**

(30) Priority: 11.10.2023 KR 20230135126
(71) Applicant: RMATERIALS CORPORATION, Yongin-si, Gyeonggi-do 17111 (KR)
(72) Inventor: RHYEE, Jong Soo, Hwaseong-si, Gyeonggi-do 18379 (KR); KIM, Young Kwang, Geumsan-gun, Chungcheongnam-do 32704 (KR); PARK, Chang Soon, Hwaseong-si, Gyeonggi-do 18401 (KR); LEE, Soon Il, Changwon-si, Gyeongsangnam-do 51151 (KR)
(74) Representative: Viering, Jentschura & Partner mbB Patent- und Rechtsanwälte
(86) International application number: PCT/KR2024/003280
(87) International publication number: WO 2025/079791

(57) **Abstract**

A method of manufacturing a low-cost and high-strength thermoelectric module with a simplified manufacturing process according to the embodiment of the present invention, the method includes: a lower metal thin film punching operation of covering an upper surface of a support, in which a plurality of through holes are formed to form a tunnel diffusion barrier, with a metal thin film for the diffusion barrier and punching and inserting the metal thin film for the diffusion barrier to match a size corresponding to each of the through holes; a thermoelectric powder filling operation of filling a space above the metal thin film for the diffusion barrier, which is inserted into each of the through holes of the support, with a p-type thermoelectric powder and an n-type thermoelectric powder; an upper metal thin film punching operation of punching and inserting the metal thin film for the diffusion barrier to match the size corresponding to each of the through holes; a thermoelectric material sintering operation of sintering the p-type thermoelectric powder and the n-type thermoelectric powder; and a thermoelectric module completing operation of completing a thermoelectric module by mounting ceramic substrates on an upper surface and a lower surface of each of the through holes that have passed through the thermoelectric material sintering operation.

## Description

### [Technical Field]

The present invention relates to a method of manufacturing a low-cost and high-strength thermoelectric module, and more specifically, to a method of manufacturing a low-cost and high-strength thermoelectric module with a simplified manufacturing process.

### [Background Art]

The main applications of thermoelectric devices allow power generation to be performed through the Seebeck effect using a temperature difference between a high temperature part, into which heat is introduced, and a low temperature part. Thermoelectric power generation aims to obtain consistent output power and efficiency by maintaining the maximum temperature difference between two ends of the thermoelectric device within the permissible range of the thermoelectric device.

Typically, the temperature difference between the two ends of the thermoelectric device is achieved by the increased thickness of the thermoelectric material. However, it is difficult to achieve the temperature difference of a certain temperature of higher in a thickness manner due to the electrical resistance and heat due to intrinsic properties of the used thermoelectric material, and it is known to waste expensive materials.

In relation, as presented in the related art document (Korean Registered Patent Publication No. 10-1384981, see FIG. 1), the problem was addressed through a spacer in a thermoelectric device. However, the thermoelectric material on the surface of the support may be formed using any of various coating methods such as metal-organic chemical vapor delocation (MOCVD), electron cyclotron resonance chemical vapor delocation (ECVD), sputtering, and spray coating methods. In this case, there are limitations in terms of practical application due to delamination between the support and the thermoelectric material and the constraints in mass production.

Therefore, there is a need for a technology that may solve the problems associated with the mentioned related art.

### [Disclosure]

### [Technical Problem]

The objective of the present invention is to address the problems associated with the related art and provide a method of manufacturing a low-cost and high-strength thermoelectric module by simplifying a plurality of thermoelectric module manufacturing processes, improving the mechanical strength of the thermoelectric module, and maintaining the performance of thermoelectric module.

### [Technical Solution]

According to one aspect of the present invention for achieving the objective, a method of manufacturing a low-cost and high-strength thermoelectric module with reduced manufacturing processes includes: a lower metal thin film punching operation of covering an upper surface of a support, in which a plurality of through holes are formed to form a tunnel diffusion barrier, with a metal thin film for the diffusion barrier and punching and inserting the metal thin film or diffusion barrier to match a size of each of the through holes, a thermoelectric powder filling operation of filling a space above the metal thin film for the diffusion barrier, which is inserted into each of the through holes of the support, with a p-type thermoelectric powder and an n-type thermoelectric powder, an upper metal thin film punching operation of covering the upper surface of the support with the metal thin film for the diffusion barrier and punching and inserting the metal thin film for the diffusion barrier to match the size of each of the through holes, a thermoelectric material sintering operation of sintering the p-type thermoelectric powder and the n-type thermoelectric powder by simultaneously applying a predetermined pressure to an upper surface and a lower surface of each of the through holes of the support and heating the inside of the through hole at a predetermined temperature, and a thermoelectric module completing operation of completing a thermoelectric module by mounting ceramic substrates on the upper surface and the lower surface of each of the through holes that have passed through the thermoelectric material sintering operation.

In the embodiment of the present invention, the lower metal thin film punching operation may include: a support preparing operation of preparing the support in which the through holes to be filled with a thermoelectric material are disposed at regular intervals and which has a structure in which each of the through holes is partitioned by metal partitions; a metal thin film preparing operation of covering the upper surface of the support with the metal thin film for the diffusion barrier which has an area equal to the upper surface of the support and has a predetermined thickness; a punching member preparing operation of preparing a cylindrical punching member which has an outer circumference equal to an inner circumference of the through hole of the support; and a punching and inserting operation of arranging the punching member at a location corresponding to the through holes on an upper surface of the metal thin film, punching the metal thin film into a shape corresponding to the through holes by applying a predetermined pressure to the metal thin film, and inserting the punched metal thin film into the through holes.

In the embodiment of the present invention, the thermoelectric powder filling operation may include: a first filling guide preparing operation of preparing a p-type powder filling guide which has a bottom surface corresponding to the upper surface of the support and has a block structure in which the same through hole is formed in the same location as each of the through holes to be filled with the p-type thermoelectric powder among the through holes of the support; a second filling guide preparing operation of preparing an n-type powder filling guide which has a bottom surface corresponding to the upper surface of the support and has a block structure in which the same through hole is formed in the same location as each of the through holes to be filled with the n-type thermoelectric powder among the through holes of the support; and a thermoelectric powder pressurizing operation of pressurizing the thermoelectric powder, which fills the through holes, by inserting the punching member into the through holes formed in the support to apply a predetermined pressure.

In the embodiment of the present invention, the thermoelectric material sintering operation may include: a thermocouple installing operation of installing thermocouples on the upper and lower surfaces of the through holes of the support; a pressurizing and arranging operation of arranging punches on the upper surface and the lower surface of the through holes of the support; a heating device arranging operation of installing a spark plasma sintering (SPS) device at the through holes of the support; and a pressurizing and sintering operation of operating the thermocouples, the punches, and the SPS device for a predetermined time under a predetermined condition.

In the embodiment of the present invention, the thermoelectric module completing operation may include: a substrate preparing operation of preparing a Cu-bonded ceramic substrate which has a planar structure corresponding to the upper surface and a lower surface of the support and is connected with a copper electrode configured according to a predetermined circuit design; an adhesive material applying operation of applying an electrical adhesive material to an upper surface and a lower surface of a thermoelectric material sintered body at a location corresponding to each of the through holes that have passed through the thermoelectric material sintering operation; and an electrical bonding operation of mounting the Cu-bonded ceramic substrate on the upper surface and the lower surface of the support and electrically connecting the Cu-bonded ceramic substrate to the support through an adhesive material.

### [Advantageous Effects]

As described above, a method of manufacturing a low-cost and high-strength thermoelectric module in the present invention includes a lower metal thin film punching operation, a thermoelectric powder filling operation, an upper metal thin film punching operation, a thermoelectric material sintering operation, and a thermoelectric module completing operation, which involve particular operations, and whereby a thermoelectric device and a module assembly with a structure which improves thermal efficiency are mass-produced, which is economical because the number of the manufacturing processes is reduced from 12 to 5, allows a stable structure to be formed because of a support, and solves bonding defects in the modules caused by differences in thermoelectric element height, standing angle, standing position, and the like, which are the most common defects in the thermoelectric module process. Therefore, the method of manufacturing a low-cost and high-strength thermoelectric module which allows mass production through a simplified process can be provided.

### [Description of Drawings]

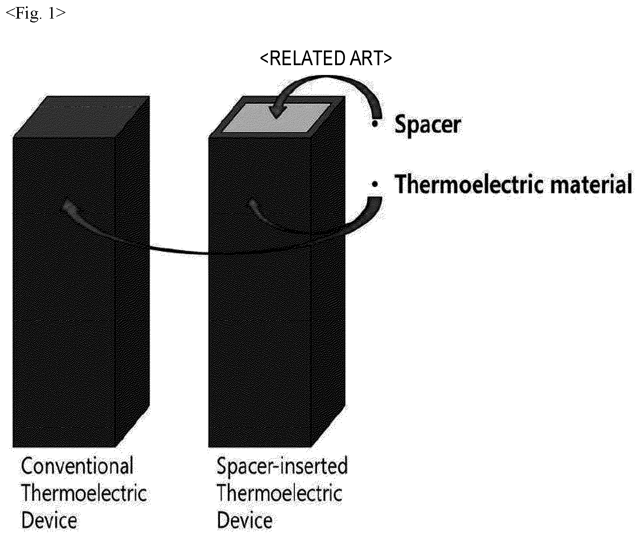

FIG. 1 is a schematic diagram showing a configuration of a thermoelectric device according to a related art.
FIG. 2 is a flowchart showing a method of manufacturing a thermoelectric module assembly according to an embodiment of the present invention.
FIG. 3 is a flowchart specifically showing a lower metal thin film punching operation of the method of manufacturing a thermoelectric module assembly shown in FIG. 2.
FIG. 4 is a flowchart specifically showing a thermoelectric powder filling operation of the method of manufacturing a thermoelectric module assembly shown in FIG. 2.
FIG. 5 is a flowchart specifically showing a thermoelectric material sintering operation of the method of manufacturing a thermoelectric module assembly shown in FIG. 2.
FIG. 6 is a flowchart specifically showing a thermoelectric module completing operation of the method of manufacturing a thermoelectric module assembly shown in FIG. 2.
FIG. 7 is a perspective view showing a metal thin film for a diffusion barrier, a support, and a punching member used in the method of manufacturing a thermoelectric module assembly according to the embodiment of the present invention.
FIG. 8 is a perspective view showing a state in which a lower nickel sealing part is mounted on a bottom surface inside of a through hole of the support after the lower metal thin film punching operation of the method of manufacturing a thermoelectric module assembly according to the embodiment of the present invention.
FIG. 9 is a perspective view showing a state in which a filling guide is mounted on an upper surface of the support in the thermoelectric powder filling operation of the method of manufacturing a thermoelectric module assembly according to the embodiment of the present invention.
FIG. 10 is a perspective view showing a state in which a masking member is installed in the filling guide shown in FIG. 9 and the filling guide is filled with a p-type thermoelectric powder.
FIG. 11 is a perspective view showing a state in which a masking member is installed in the filling guide shown in FIG. 9 and the filling guide is filled with an n-type thermoelectric powder.
FIG. 12 is a perspective view showing a state in which a p-type thermoelectric powder and an n-type thermoelectric powder are filled using the filling guide shown in FIG. 9.
FIG. 13 is a perspective view showing a thermoelectric powder pressurizing operation of a thermoelectric powder filling operation in the method of manufacturing a thermoelectric module assembly according to the embodiment of the present invention and a state in which the p-type thermoelectric powder and the n-type thermoelectric powder shown in FIG. 12 are pressurized by the punching member.
FIG. 14 is a perspective view showing an upper metal thin film punching operation in the method of manufacturing a thermoelectric module assembly according to the embodiment of the present invention, and a state in which an upper nickel sealing part is mounted on an upper surface of the thermoelectric powder filling the through holes of the support shown in FIG. 13.
FIG. 15 is a perspective view showing a state in which a Cu-bonded ceramic substrate is installed on each of an upper surface and a lower surface of the support in a thermoelectric module completing operation of the method of manufacturing a thermoelectric module assembly according to the embodiment of the present invention.

### [Best Modes of the Invention]

Hereinafter, embodiments of the present invention will be described in detail with reference to the accompanying drawings. Prior to this, it should be noted that the terms or words used in the specification and claims should not be interpreted as being limited to their ordinary or dictionary meanings, but they should be interpreted based on the meaning and concept corresponding to the technological spirit of the present invention.

Through the specification, when an element is referred to as being "on" another element, it includes cases where the element is directly connected to the other element, as well as cases where another element is present between the two elements. Throughout the specification, when a part is referred to as "comprising" a component, it means that the part may further include other components without excluding another component, unless specifically stated otherwise.

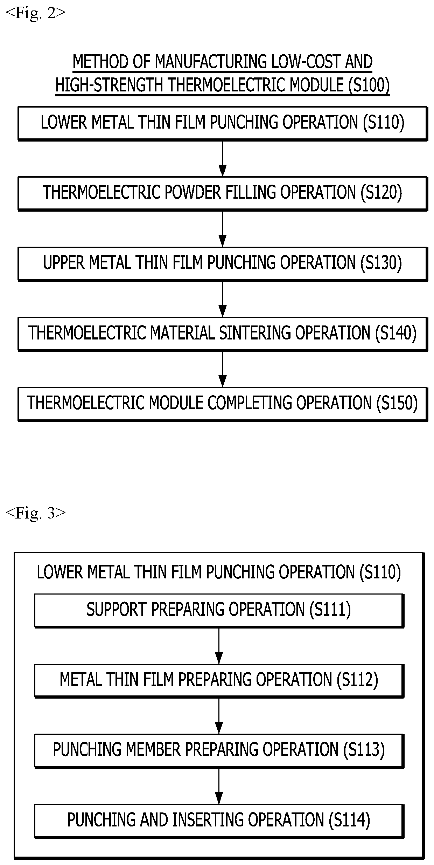

FIG. 2 is a flowchart showing a method of manufacturing a thermoelectric module assembly according to an embodiment of the present invention.

Referring to FIG. 2, a low-cost and high-strength thermoelectric module manufacturing method S100 according to the embodiment of the present invention includes a lower metal thin film punching operation S110, a thermoelectric powder filling operation S120, an upper metal thin film punching operation S130, a thermoelectric material sintering operation S140, and a thermoelectric module completing operation S150, which involve particular operations. Therefore, the method of manufacturing a low-cost and high-strength thermoelectric module, through which thermoelectric devices and a module assembly with a structure which improves thermal efficiency can be mass-produced, can be economical because the number of the manufacturing processes is reduced from 12 to 5, can allow a stable structure to be formed because of a support 110, and can solve bonding defects in the modules caused by differences in thermoelectric element height, standing angle, and standing position, which are the most common defects in the thermoelectric module process, thereby allowing mass production through a simplified process.

Hereinafter, each operation of the low-cost and high-strength thermoelectric module manufacturing method S100 according to the embodiment of the present invention will be described in detail with reference to the accompanying drawings.

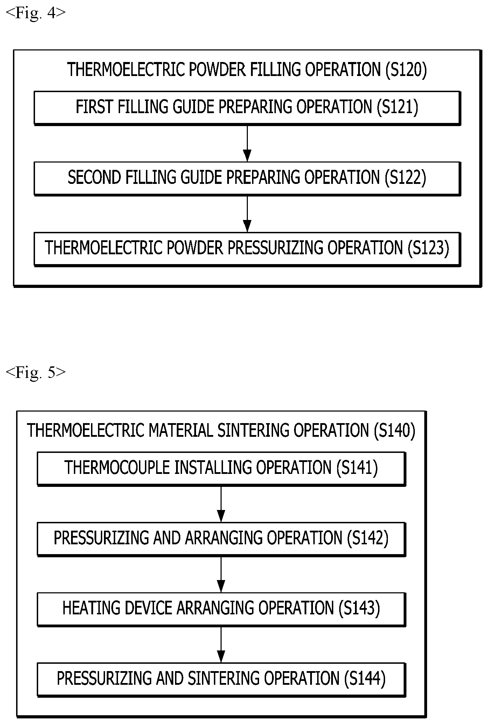

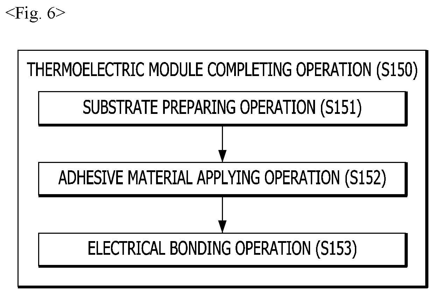

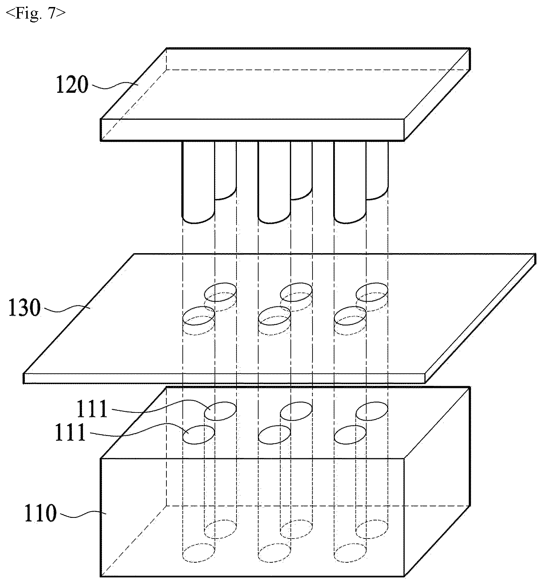

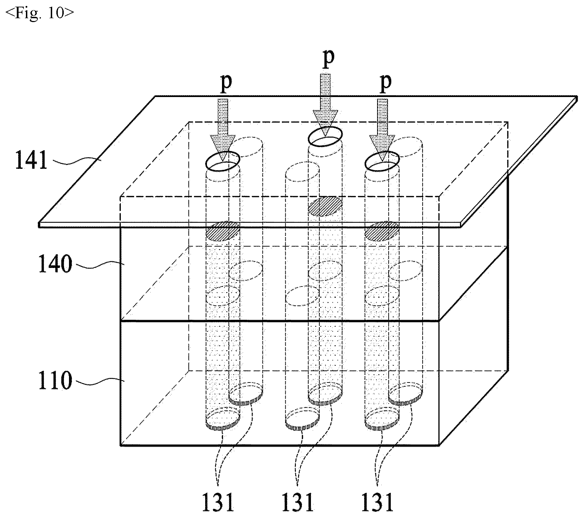

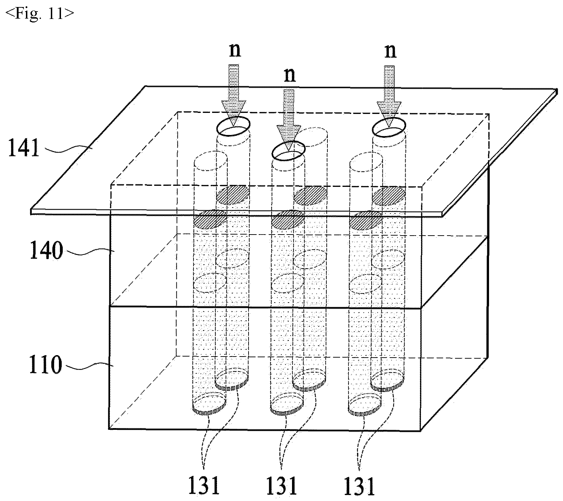

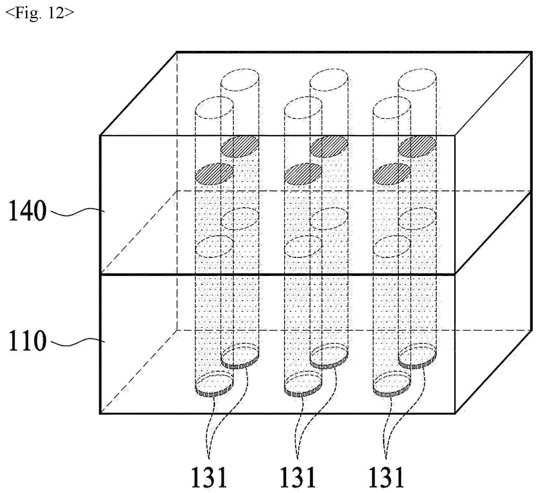

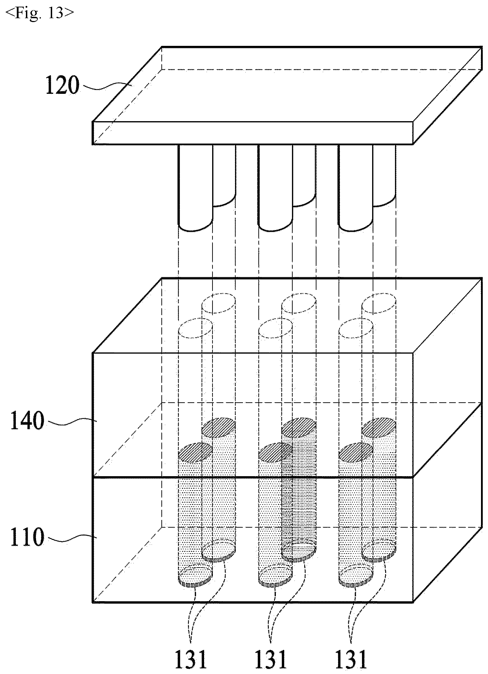

FIGS. 3 to 6 show flowcharts of operations of the method of manufacturing a thermoelectric module assembly according to the present embodiment in more detail. FIGS. 7 to 15 show process schematic diagrams which illustrate operations of the method of manufacturing a thermoelectric module assembly according to the present embodiment in more detail.

Referring sequentially to FIGS. 2 to 15, the lower metal thin film punching operation S110 of the low-cost and high-strength thermoelectric module manufacturing method S100 according to the present embodiment involves covering an upper surface of the support 110, in which a plurality of through holes 111 are formed to form a tunnel diffusion barrier, with the metal thin film 130 for the diffusion barrier, and punching and inserting the thin film 130 for the diffusion barrier to match a size of each of the through holes 111. The mentioned metal thin film 130 for the diffusion barrier may be made of nickel metal, another metal, or an alloy material.

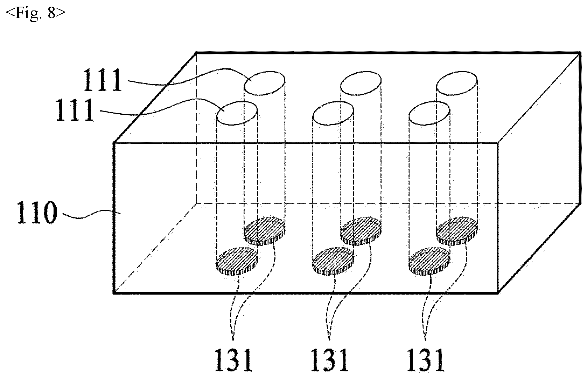

Specifically, the lower metal thin film punching operation S110 may include a support preparing operation S111, a metal thin film preparing operation S112, a punching member preparing operation S113, and a punching and inserting operation S114, which involve particular operations. As shown in FIGS. 7 and 8, the support preparing operation S111 includes arranging a plurality of through holes 111, which are filled with thermoelectric materials, at regular intervals and preparing a support 110 which has a structure in which each of the through holes 111 is partitioned by metal partitions. The metal thin film preparing operation S112 includes covering the upper surface of the support 110 with the metal thin film 130 for the diffusion barrier, wherein the metal thin film has a predetermined thickness and has an area equal to an upper surface of the support 110. The punching member preparing operation S113 includes preparing a cylindrical punching member 120 with an outer diameter equal to the inner diameter of the through-hole 111 of the support 110. Also, the punching and inserting operation S114 includes arranging the punching member 120 at a portion corresponding to the through holes 111 on the upper surface of the metal thin film, and punching and inserting the metal thin film to match a shape corresponding to the through holes 111 by applying a predetermined pressure to the metal thin film.

The thermoelectric powder filling operation S120 according to the embodiment of the present invention includes covering upper portions of the metal thin films 130 for the diffusion barrier inserted into the through holes 111 of the support 110 with a p-type thermoelectric powder and an n-type thermoelectric powder.

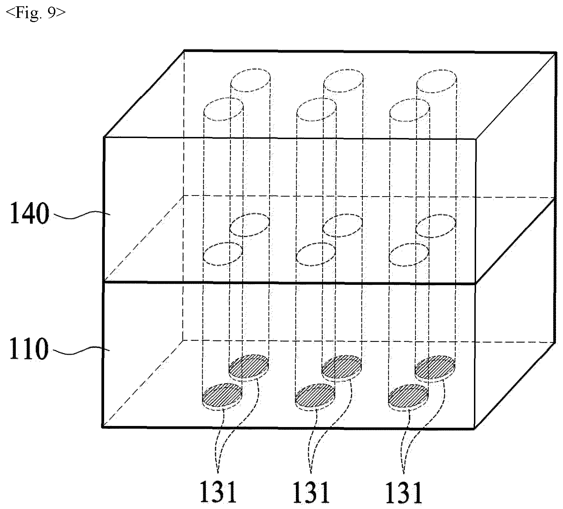

Specifically, as shown in FIGS. 9 to 13, the thermoelectric powder filling operation S120 according to the embodiment of the present invention includes a first filling guide preparing operation S121, a second filling guide preparing operation S122, and a thermoelectric powder pressurizing operation S123, which involve particular operations. The first filling guide preparing operation S121 includes preparing a p-type powder filling guide 140 which has a bottom surface corresponding to the upper surface of the support 110 and has a block structure in which the same through hole 111 is formed in the same location as each of the through holes 111 to be filled with the p-type thermoelectric powder among the through holes 111 of the support 110, the second filling guide preparing operation S122 includes preparing an n-type powder filling guide 140 which has a bottom surface corresponding to the upper surface of the support 110 and has a block structure in which the same through hole 111 is formed in the same location as each of the through holes 111 to be filled with the n-type thermoelectric powder among the through holes 111 of the support 110. Also, the thermoelectric powder pressurizing operation S123 includes pressurizing the thermoelectric powder, which fills the through holes 111, by inserting the punching member 120 into the through holes 111 formed in the support 110 to apply a predetermined pressure.

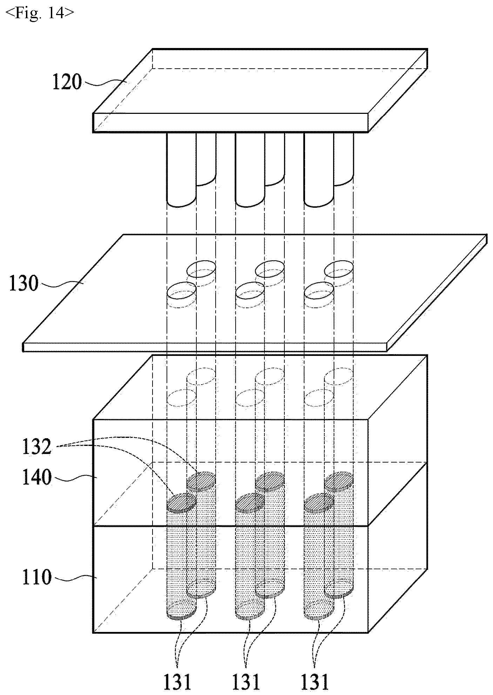

The upper metal thin film punching operation S130 according to the embodiment of the present invention, as shown in FIG. 14, includes covering the upper surface of the support 110 with the metal thin film 130 for the diffusion barrier and punching and inserting the metal thin film 130 for the diffusion barrier to match a size corresponding to each of the through holes 111.

The thermoelectric material sintering operation S140 according to the present invention includes sintering the p-type thermoelectric powder and the n-type thermoelectric powder by simultaneously applying a predetermined pressure to the upper surface and the lower surface of the through hole 111 of the support 110 and heating the through holes 111 at a predetermined temperature.

Specifically, the thermoelectric material sintering operation S140 may include a thermocouple installing operation S141, a pressurizing and arranging operation S142, a heating device arranging operation S143, and a pressurizing and sintering operation S144, which involve particular operations. The thermocouple installing operation S141 includes a process of installing thermocouples on the upper and lower surfaces of the through holes 111 of the support 110. The pressurizing and arranging operation S142 includes a process of arranging punches on the upper surface and the lower surface of the through holes 111 of the support 110. The heating device arranging operation S143 includes a process of installing a spark plasma sintering (SPS) device at the through hole 111 of the support 110. Also, the pressurizing and sintering operation S144 includes a process of operating the thermocouples, the punches, and the SPS device for a predetermined time under a predetermined condition.

The thermoelectric module completing operation S150 according to the present invention includes a process of completing a thermoelectric module by mounting ceramic substrates on the upper surface and the lower surface of the through holes 111 that have passed through the thermoelectric material sintering operation.

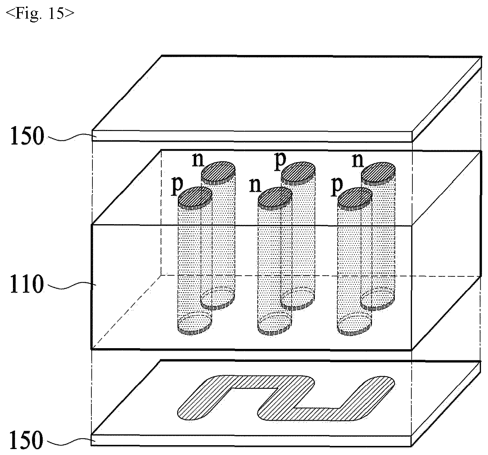

Specifically, as shown in FIG. 15, the thermoelectric module completing operation S150 according to the present invention may include a substrate preparing operation S151, an adhesive material applying operation S152, and an electrical bonding operation S153. The substrate preparing operation S151 includes a process of preparing a Cu-bonded ceramic substrate which has a planar structure corresponding to an upper surface and a lower surface of the support 110 and is connected with a copper electrode configured according to a predetermined circuit design. The adhesive material applying operation S152 includes a process of applying an electrical adhesive material to an upper surface and a lower surface of a thermoelectric material sintered body at a location corresponding to each of the through holes 111 that have passed through the thermoelectric material sintering operation S140. Also, the electrical bonding operation S153 includes a process of mounting the Cu-bonded ceramic substrate on the upper surface and the lower surface of the support 110 and electrically connecting the Cu-bonded ceramic substrate the support 110 through an adhesive material.

As described above, the method of manufacturing a low-cost and high-strength thermoelectric module of the present invention includes a lower metal thin film punching operation S110, a thermoelectric powder filling operation S120, an upper metal thin film punching operation S130, a thermoelectric material sintering operation S140, and a thermoelectric module completing operation S150, which involve particular operations, whereby thermoelectric devices and a module assembly with a structure which improves thermal efficiency are mass-produced, which is economical because the number of the manufacturing processes is reduced from 12 to 5, allows a stable structure to be formed because of the support 110, and solves bonding defects in the modules caused by differences in thermoelectric element height, standing angle, and standing position, which are the most common defects in the thermoelectric module process. Therefore, the method of manufacturing a low-cost and high-strength thermoelectric module which allows mass production through a simplified process can be provided.

The detailed description of the present invention has been provided only for specific embodiments thereof. However, it should be understood that the present invention is not limited to the specific forms mentioned in the detailed description. Instead, the present invention should be construed to include all modifications, equivalents, and alternatives falling within the spirit and scope of the present invention as defined by the appended claims.

Accordingly, the present invention is not limited to the specific embodiments and descriptions. Various modifications can be made by those skilled in the art without departing from the gist of the present invention as claimed in the claims, and the modifications are intended to be within the protection scope of the present invention.

### [Modes of the Invention]

The mode for implementing the present invention has been described with the best mode for carrying out the above invention.

### [Industrial Applicability]

The present invention relates to a method of manufacturing a low-cost and high-strength thermoelectric module with a simplified manufacturing process which includes a lower metal thin film punching operation, a thermoelectric powder filling operation, an upper metal thin film punching operation, a thermoelectric material sintering operation, and a thermoelectric module completing operation, which involve particular processes, whereby thermoelectric devices and module assemblies with a structure which improves thermal efficiency are mass-produced, which is economical because the number of the manufacturing processes is reduced from 12 to 5, allows a stable structure to be formed because of a support, and solves bonding defects in the modules caused by differences in thermoelectric element height, standing angle, and standing position, which are the most common defects in the thermoelectric module process. Therefore, the method of manufacturing a low-cost and high-strength thermoelectric module, which allows mass production through a simplified process, can be provided, making it applicable for industrial use.

## Claims

1. A method of manufacturing a low-cost and high-strength thermoelectric module, the method comprising:
a lower metal thin film punching operation (S110) of covering an upper surface of a support (110), in which a plurality of through holes (111) are formed to form a tunnel diffusion barrier, with a metal thin film (130) for the diffusion barrier and punching and inserting the metal thin film (130) for the diffusion barrier to match a size of each of the through holes (111);
a thermoelectric powder filling operation (S120) of filling a space above the metal thin film (130) for the diffusion barrier, which is inserted into each of the through holes (111) of the support (110), with a p-type thermoelectric powder and an n-type thermoelectric powder;
an upper metal thin film punching operation (S130) of covering the upper surface of the support (110) with the metal thin film (130) for the diffusion barrier and punching and inserting the metal thin film (130) for the diffusion barrier to match the size of each of the through holes (111);
a thermoelectric material sintering operation (S140) of sintering the p-type thermoelectric powder and the n-type thermoelectric powder by simultaneously applying a predetermined pressure to an upper surface and a lower surface of each of the through holes (111) of the support (110) and heating inside of the through hole (111) at a predetermined temperature; and
a thermoelectric module completing operation (S150) of completing a thermoelectric module by mounting ceramic substrates on the upper surface and the lower surface of each of the through holes (111) that have passed through the thermoelectric material sintering operation.

2. The method of claim 1, wherein the lower metal thin film punching operation (S110) includes:
a support preparing operation (S111) of preparing the support (110) in which the through holes (111) to be filled with a thermoelectric material are disposed at regular intervals and which has a structure in which each of the through holes (111) is partitioned by metal partitions;
a metal thin film preparing operation (S112) of covering the upper surface of the support (110) with the metal thin film (130) for the diffusion barrier which has an area equal to the upper surface of the support (110) and has a predetermined thickness;
a punching member preparing operation (S113) of preparing a cylindrical punching member (120) which has an outer circumference equal to an inner circumference of the through hole (111) of the support (110); and
a punching and inserting operation (S114) of arranging the punching member (120) at a location corresponding to the through holes (111) on an upper surface of the metal thin film, punching the metal thin film into a shape corresponding to the through holes (111) by applying a predetermined pressure to the metal thin film, and inserting the punched metal thin film into the through holes (111).

3. The method of claim 2, wherein the thermoelectric powder filling operation (S120) includes:
a first filling guide preparing operation (S121) of preparing a p-type powder filling guide (140) which has a bottom surface corresponding to the upper surface of the support (110) and has a block structure in which the same through hole (111) is formed in the same location as each of the through holes (111) to be filled with the p-type thermoelectric powder among the through holes (111) of the support (110);
a second filling guide preparing operation (S122) of preparing an n-type powder filling guide (140) which has a bottom surface corresponding to the upper surface of the support (110) and has a block structure in which the same through hole (111) is formed in the same location as each of the through holes (111) to be filled with the n-type thermoelectric powder among the through holes (111) of the support (110); and
a thermoelectric powder pressurizing operation (S123) of pressurizing the thermoelectric powder, which fills the through holes (111), by inserting the punching member (120) into the through holes (111) formed in the support (110) to apply a predetermined pressure.

4. The method of claim 1, wherein the thermoelectric material sintering operation (S140) includes:
a thermocouple installing operation (S141) of installing thermocouples on the upper and lower surfaces of the through holes (111) of the support (110);
a pressurizing and arranging operation (S142) of arranging punches on the upper surface and the lower surface of the through holes (111) of the support (110);
a heating device arranging operation (S143) of installing a spark plasma sintering (SPS) device at the through holes (111) of the support (110); and
a pressurizing and sintering operation (S144) of operating the thermocouples, the punches, and the SPS device for a predetermined time under a predetermined condition.

5. The method of claim 1, wherein the thermoelectric module completing operation (S150) includes:
a substrate preparing operation (S151) of preparing a Cu-bonded ceramic substrate which has a planar structure corresponding to the upper surface and a lower surface of the support (110) and is connected with a copper electrode configured according to a predetermined circuit design;
an adhesive material applying operation (S152) of applying an electrical adhesive material to an upper surface and a lower surface of a thermoelectric material sintered body at a location corresponding to each of the through holes (111) that have passed through the thermoelectric material sintering operation (S140); and
an electrical bonding operation (S153) of mounting the Cu-bonded ceramic substrate on the upper surface and the lower surface of the support (110) and electrically connecting the Cu-bonded ceramic substrate to the support (110) through an adhesive material.
